# EUROPÄISCHE PATENTSCHRIFT

(11) **EP 2 692 058 B1**
(45) Veröffentlichungstag und Bekanntmachung des Hinweises auf die Patenterteilung: **10.02.2016**
(21) Anmeldenummer: 12714591.0
(22) Anmeldetag: 13.03.2012
(51) Int. Cl.: H03G 3/30

(54) **VORRICHTUNG UND VERFAHREN ZUM FIXIEREN EINES VERSTÄRKUNGS- BZW. DÄMPFUNGSFAKTORS**
APPARATUS AND METHOD FOR FIXING A GAIN OR ATTENTUATION FACTOR
DISPOSITIF ET PROCÉDÉ POUR FIXER UN FACTEUR D'AMPLIFICATION OU D'AMORTISSEMENT

(30) Priorität: 31.03.2011 DE 102011006571; 19.08.2011 DE 102011081245
(43) Veröffentlichungstag der Anmeldung: 05.02.2014
(73) Patentinhaber: Rohde & Schwarz GmbH & Co. KG, 81671 München (DE)
(72) Erfinder: KUHWALD, Thomas, 85570 Markt Schwaben (DE); VALTEN, Thomas, 82008 Unterhaching (DE)
(74) Vertreter: Körfer, Thomas
(86) Internationale Anmeldenummer: PCT/EP2012/054389
(87) Internationale Veröffentlichungsnummer: WO 2012/130610

(56) Entgegenhaltungen:
- EP-A2- 0 455 388
- US-A1- 2001 028 275
- US-A1- 2008 291 975
- US-A1- 2009 310 690
- US-B1- 7 151 759
- US-B1- 7 212 798

## Beschreibung

Die Erfindung betrifft eine Vorrichtung und ein Verfahren zum Fixieren eines Verstärkungs- bzw. Dämpfungsfaktors für ein Verstärkungs- oder Dämpfungsglied.

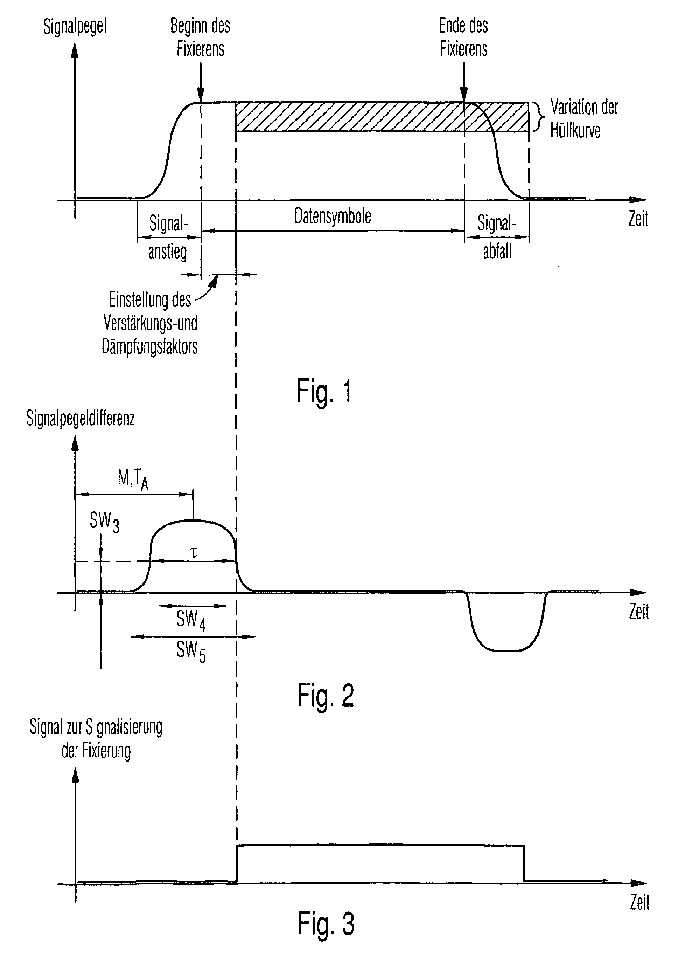

Zur Zeitsynchronisation zwischen sendenden und empfangenden Funkgerät wird bevorzugt eine spezielle Sequenz von Synchronisationsdatensymbolen, ein so genanntes Synchronisations-Hop, gemäß Fig. 1 übertragen. Im empfangenden Funkgerät werden zur Ermittlung einer Zeit-Referenz die empfangenen Synchronisationsdatensymbole mit den dem empfangenden Funkgerät bekannten Referenz-Synchronisationsdatensymbolen korreliert. Der Zeitpunkt des Korrelation-Maximums stellt einen Referenz-Zeitpunkt dar. Die Synchronisationsdatensymbole werden in einem Frequenzsprungverfahren bevorzugt mit einem linearen Modulationsverfahren übertragen. Dies hat eine Variation der Hüllkurve der Sequenz von Synchronisationsdatensymbolen zur Folge, wie in Fig. 1 durch die grau schraffierte Fläche angedeutet ist.

Durch die Variation der Hüllkurve wie auch durch Amplitudenverzerrung im Übertragungskanal und durch überlagertes Amplitudenrauschen verändert sich der Signalpegel des Empfangssignals des Funkgeräts. Eine Änderung des Signalpegels des Empfangssignals führt zur Aktivierung einer automatischen Verstärkungsregelung (Automatic Gain Control (AGC)) der einzelnen hinsichtlich ihres Verstärkungsfaktors bzw. Dämpfungsfaktors einstellbaren Verstärker bzw. Dämpfungsglieder im Eingangssignalpfad des Funkgeräts. Eine AGC-Regelung geht beispielsweise aus der US 7,853,224 B2 hervor. Die Änderung des Hüllkurvenpegels des Empfangssignals führt wiederum nachteilig zu einer fehlerhaften Detektion des Empfangssignals. Das Dokument EP 0 455 388 A2 beschreibt einen Empfänger für mobile Telefone mit Fixieren das Verstärkungsfaktors.

Aufgabe der Erfindung ist es deshalb, eine automatische Einstellung eines Verstärkungs- bzw. Dämpfungsfaktors für ein Verstärkungs- oder Dämpfungsglied derart weiterzuentwickeln, dass eine fehlerfreie Detektion einer Sequenz von Synchronisationsdatensymbolen gewährleistet ist.

Der Aufgabe wird durch ein Verfahren zum Fixieren eines Verstärkungs- bzw. Dämpfungsfaktors für ein Verstärkungs- oder Dämpfungsglied mit den Merkmalen des Patentanspruchs 1 und eine Vorrichtung zum Fixieren eines Verstärkungs- bzw. Dämpfungsfaktors für ein Verstärkungs- oder Dämpfungsglied mit den Merkmalen des Patentanspruchs 9 gelöst. Vorteilhafte technische Erweiterungen sind in den jeweils abhängigen Patentansprüchen aufgeführt.

Das erfindungsgemäße Verfahren und die erfindungsgemäße Vorrichtung erfassen jeweils den Signalpegel des Empfangssignals mit einem ersten Detektor am Eingang des jeweiligen Verstärkungs- oder Dämpfungsgliedes und identifizieren in einer ersten Einheit auf der Basis des erfassten Signalpegel-Verlaufs den Übertragungsbeginn der Sequenz von Synchronisationsdatensymbolen. Sobald der Übertragungsbeginn der Sequenz von Synchronisationsdatensymbolen identifiziert wird, wird der Verstärkungs- bzw. Dämpfungsfaktor des jeweiligen Verstärkungs- oder Dämpfungsgliedes auf den im Zeitpunkt des Übertragungsbeginns der Sequenz von Synchronisationsdatensymbolen eingestellten Verstärkungs- bzw. Dämpfungsfaktors fixiert. Hierzu wird von einer zweiten Einheit dem jeweiligen Verstärkungs- oder Dämpfungsglied ein Signal zugeführt, das das Zeitintervall der Fixierung des Verstärkungs- bzw. Dämpfungsfaktors signalisiert. Durch die Fixierung des Verstärkungs- bzw. Dämpfungsfaktors kommt es während der Übertragungsdauer der Sequenz von Synchronisationsdatensymbolen zu keiner Veränderung des Signalpegels der Synchronisationsdatensymbole am Eingang des Detektors, der die Synchronisationsdatensymbole aus dem Empfangssignal bestimmt, und damit vorteilhaft zu keiner fehlerbehafteten Detektion der Synchronisationsdatensymbole.

Die Fixierung des Verstärkungs- bzw. Dämpfungsfaktors im jeweiligen Verstärkungs- oder Dämpfungsglied endet vorzugsweise spätestens mit Ablauf der Übertragung der Sequenz von Synchronisationsdatensymbolen.

Sinkt der Signalpegel der einzelnen empfangenen Synchronisationsdatensymbolen vor Ablauf der Übertragung der Sequenz von Synchronisationsdatensymbolen unter einen gültigen Schwellwert, so ist mit einem ungültigen Signalpegel des Empfangssignals, der in den Eingangsdynamikbereich einer nachfolgenden Signalverarbeitungsstufe nicht mehr passt, nicht zu rechnen und eine Fixierung des Verstärkungs- oder Dämpfungsfaktors somit nicht mehr erforderlich und kann vorzugsweise aufgehoben werden. Hierzu wird der vom ersten Detektor am Eingang des jeweiligen Verstärkungs- oder Dämpfungsgliedes erfasste Signalpegel des Empfangssignals über ein bestimmtes Mittelungsintervall gemittelt, um ein fehlerhaftes Aufheben der Fixierung des Verstärkungs- bzw. Dämpfungsfaktors aufgrund eines kurzzeitigen Signalpegelabfalls zu vermeiden. Die gemittelten Signalpegelwerte werden anschließend in einem ersten Vergleicher mit einem ersten Schwellwert zur Identifizierung eines vorzeitig beendeten Fixierens verglichen, unterhalb dessen mit keinem ungültigen Signalpegel des Empfangssignals zu rechnen ist.

Unterschreiten die gemittelten Signalpegelwerte diesen ersten Schwellwert, so signalisiert der erste Vergleicher der zweiten Einheit, die dem Verstärkungs- oder Dämpfungsglied das Zeitintervall des Fixierens des Verstärkungs- bzw. Dämpfungsfaktors signalisiert, ein frühzeitiges Aufheben der Fixierung des Verstärkungs- bzw. Dämpfungsfaktors. Anstelle von Signalpegelwerten können bevorzugt auch Leistungspegelwerte verwendet werden und sind von der Erfindung auch mit abgedeckt.

Ab dem Beginn der Fixierung des Verstärkungs- bzw. Dämpfungsfaktors wird vorzugsweise der Signalpegel des Empfangssignals an einzelnen Stellen im Eingangssignalpfad des Funkgeräts im Hinblick auf ein Überschreiten eines zweiten Schwellwerts geprüft, bei dem es zu einer nicht akzeptablen Übersteuerung eines oder mehrerer Signalverarbeitungseinheiten im Eingangssignalpfad des Funkgeräts, beispielsweise eines Verstärkers oder eines Analog-Digital-Wandlers, kommt. Bei einer Überschreitung dieses zweiten Schwellwerts durch den Signalpegel des Empfangssignal wird die Fixierung des Verstärkungs- bzw. Dämpfungsfaktors des jeweiligen Verstärkungs- oder Dämpfungsgliedes eine bestimmte erste Zeitdauer ausgesetzt, um in dieser ersten Zeitdauer mit einem veränderten Verstärkungs- bzw. Dämpfungsfaktor des jeweiligen Verstärkungs- oder Dämpfungsgliedes den Signalpegel des Empfangssignals am Ausgang des jeweiligen Verstärkungs- oder Dämpfungsgliedes auf einen Wert unterhalb des zweiten Schwellwerts zu reduzieren.

Hierzu wird in einer dritten Einheit bevorzugt ein derartiger ungültiger Signalpegel des Empfangssignals identifiziert und der zweiten Einheit ein zeitweises Aussetzen der Fixierung des Verstärkungs- bzw. Dämpfungsfaktors signalisiert.

In einer ersten Ausführungsform des zeitweisen Aussetzens der Fixierung des Verstärkungs- bzw. Dämpfungsfaktors wird hierzu vorzugsweise in einer zur dritten Einheit gehörigen ersten Speichereinheit der vom ersten Detektor erfasste Signalpegel des am Eingang des jeweiligen Verstärkungs- bzw. Dämpfungsgliedes anliegenden Signals im Zeitpunkt des Übertragungsbeginns der Sequenz von Synchronisationsdatensymbolen gespeichert und in einem nachfolgenden ebenfalls zur dritten Einheit gehörigen Addierer zum zweiten Schwellwert addiert. Ein in jedem Zeitpunkt aktuell in einer ebenfalls zur dritten Einheit gehörigen zweiten Speichereinheit abgelegter, vom ersten Detektor erfasster Signalpegel des am Eingang des jeweiligen Verstärkungs- bzw. Dämpfungsgliedes anliegenden Signals wird in einem ebenfalls zur dritten Einheit gehörigen zweiten Vergleicher im Hinblick auf ein Überschreiten des um den zweiten Schwellwert erhöhten Signalpegels des vom ersten Detektor am Eingang des jeweiligen Verstärkungs- bzw. Dämpfungsgliedes anliegenden Empfangssignals im Zeitpunkt des Übertragungsbeginns der Sequenz von Synchronisationsdatensymbolen verglichen.

Wird vom zweiten Vergleicher ein Überschreiten identifiziert, so liegt ein ungültiger Signalpegel des Empfangssignals vor, der zu einer unerwünschten Übersteuerung einer Signalverarbeitungseinheit führt. Dieser ungültige Signalpegel wird bevorzugt von der dritten Einheit der zweiten Einheit signalisiert, die wiederum dem Verstärkungs- oder Dämpfungsglied die zeitweise Aufhebung der Fixierung des Verstärkungs- bzw. Dämpfungsfaktors signalisiert.

In einer zweiten Ausführungsform des zeitweisen Aussetzens der Fixierung des Verstärkungs- bzw. Dämpfungsfaktors wird der vom ersten Detektor erfasste Signalpegel des am Eingang des jeweiligen Verstärkungs- bzw. Dämpfungsgliedes anliegenden Empfangssignals in einem zur dritten Einheit gehörigen Multiplizierer mit dem Verstärkungs- bzw. Dämpfungsfaktor des jeweiligen Verstärkungs- bzw. Dämpfungsgliedes gewichtet und der somit gewichtete Signalpegel des Empfangssignals in einem zur dritten Einheit gehörigen zweiten Vergleicher im Hinblick auf ein Überschreiten des zweiten Schwellwerts geprüft. Wird vom zweiten Vergleicher ein Überschreiten identifiziert, so liegt ebenfalls ein kritischer Signalpegel des Empfangssignals vor, der von der dritten Einheit der zweiten Einheit zur zeitweisen Aussetzung der Fixierung des Verstärkungs- bzw. Dämpfungsfaktors signalisiert wird.

In einer dritten Ausführungsform des zeitweisen Aussetzens die Fixierung des Verstärkungs- bzw. Dämpfungsfaktors wird ein von einem zweiten Detektor erfasste Signalpegel des am Ausgang des jeweiligen Verstärkungs- bzw. Dämpfungsgliedes anliegenden Empfangssignals in einem zur dritten Einheit gehörigen zweiten Vergleicher mit einem zweiten Schwellwerts verglichen. Wird vom zweiten Vergleicher ein Überschreiten des zweiten Schwellwerts durch den erfassten Signalpegel des Empfangssignals am Ausgang des Verstärkungs- bzw. Dämpfungsgliedes identifiziert, so liegt ebenfalls ein kritischer Signalpegel des Empfangssignals vor, der von der dritten Einheit der zweiten Einheit zur zeitweisen Aussetzung der Fixierung des Verstärkungs- bzw. Dämpfungsfaktors signalisiert wird.

Die Überprüfung des Signalpegels des Empfangssignals im Hinblick auf eine Identifizierung eines ungültigen Signalpegels des Empfangssignals, die mit dem Übertragungsbeginn der Sequenz von Synchronisationsdatensymbolen und damit mit dem Beginn des Fixierens des Verstärkungs- bzw. Dämpfungsfaktors des jeweiligen Verstärkungs- oder Dämpfungsgliedes beginnt, wird bevorzugt nur über eine bestimmte zweite Zeitdauer durchgeführt, die gegenüber der gesamten Übertragungszeit der Sequenz von Synchronisationsdatensymbolen reduziert ist. Ein am Ende der Übertragungszeit der Sequenz von Synchronisationsdatensymbolen auftretender kritischer Signalpegel des Empfangssignals wird somit ignoriert, da in diesem Fall auch bei einer schnellen AGC-Regelung die für das korrekte Einstellen des Verstärkungs- bzw. Dämpfungsfaktors nötige Zeit nicht mehr vorhanden ist.

Zur Identifizierung des Übertragungsbeginns der Sequenz von Synchronisationsdaten und damit des Beginns der Fixierung des Verstärkungs- bzw. Dämpfungsfaktors werden vorzugsweise in einem zur ersten Einheit gehörigen Differenzbildner Differenzen von jeweils aufeinander folgenden Signalpegelwerten des vom ersten Detektor am Eingang des jeweiligen Verstärkungs- oder Dämpfungsgliedes erfassten Empfangssignals ermittelt. Mit der Differenzbildung kann die Anstiegsflanke einer Sequenz von Synchronisationsdatensymbolen identifiziert werden.

In einer sich bevorzugt anschließenden Matched-Filterung in einem zur ersten Einheit gehörigen Matched-Filter werden im Empfangssignal enthaltene Störsignalanteile, beispielsweise überlagertes Rauschen oder Nebenkanal-Übersprechen, gedämpft bzw. beseitigt.

In einem anschließenden ebenfalls zur ersten Einheit gehörigen dritten Vergleicher werden die gefilterten Signalpegel-Differenzen des Empfangssignals bevorzugt mit einem dritten Schwellwert auf Überschreiten verglichen. Da der Verlauf der gefilterten Signalpegel-Differenzen des Empfangssignals typischerweise den Verlauf eines geglätteten Rechteckpulses aufweist, ergibt der Vergleich mit dem dritten Schwellwert ein Zeitintervall zwischen dem beiden Zeitpunkten des Überschreitens und des Unterschreitens des dritten Schwellwerts, in dem die Anstiegsgeschwindigkeit der Anstiegsflanke der Sequenz von Synchronisationsdatensymbolen oberhalb einer Mindestanstiegsgeschwindigkeit liegt.

Durch Vergleich des Zeitintervalls, in der die Anstiegsflanke der Sequenz von Synchronisationsdatensymbolen eine oberhalb der Mindestanstiegsgeschwindigkeit liegende Anstiegsgeschwindigkeit aufweist, in einem ebenfalls zur ersten Einheit gehörigen vierten bzw. fünften Vergleicher mit einem vierten bzw. fünften Schwellwert kann vorzugsweise überprüft werden, ob dieses ermittelte Zeitintervall innerhalb eines durch den vierten bzw. fünften Schwellwert festgelegten Toleranzbereiches liegt. Ist dies der Fall, so liegt eindeutig eine Signalflanke einer Sequenz von Synchronisationsdatensymbolen und damit der Zeitpunkt des Übertragungsbeginns einer Sequenz von Synchronisationsdatensymbolen vor, der von der ersten Einheit der zweiten Einheit signalisiert wird.

Die erfindungsgemäße Vorrichtung und das erfindungsgemäße Verfahren zum Fixieren eines Verstärkungs- bzw. Dämpfungsfaktors eines Verstärkungs- oder Dämpfungsgliedes werden im Folgenden anhand der Zeichnung im Detail erläutert. Die Figuren der Zeichnung zeigen:
- Fig. 1: ein Zeitdiagramm einer Sequenz von Synchronisationsdatensymbolen,
- Fig. 2: ein Zeitdiagramm eines Verlaufs von Signalpegel-Differenzen der zugehörigen Sequenz von Synchronisationsdatensymbolen,
- Fig. 3: ein Zeitdiagramm eines zugehörigen Signals zum Fixieren des Verstärkungs- bzw. Dämpfungsfaktors,
- Fig. 4: ein Zeitdiagramm einer Sequenz von Synchronisationsdatensymbolen mit abnehmenden Signalpegel,
- Fig. 5: ein Zeitdiagramm einer Sequenz von Synchronisationsdatensymbolen mit ungültigen Signalpegelwerten,
- Fig. 6: ein Zeitdiagramm einer Sequenz von Synchronisationsdatensymbolen mit ungültigen Signalpegelwerten bei zeitweisen Aussetzen des Fixierens des Verstärkungs- bzw. Dämpfungsfaktors,
- Fig. 7: ein Zeitdiagramm eines in der ersten Speichereinheit gespeicherten Signalpegels,
- Fig. 8: ein Zeitdiagramm eines in der zweiten Speichereinheit gespeicherten Signalpegels,
- Fig. 9: ein Zeitdiagramm eines zugehörigen Signals zum Signalisieren eines ungültigen Signalpegelwerts,
- Fig. 10: ein Zeitdiagramm eines zugehörigen Signals zum Fixieren des Verstärkungs- bzw. Dämpfungsfaktors,
- Fig. 11: ein Blockdiagramm einer erfindungsgemäßen Vorrichtung zum Fixieren eines Verstärkungs- bzw. Dämpfungsfaktors eines Verstärkungs- oder Dämpfungsgliedes,
- Fig. 12A,12B,12C: ein Blockdiagramm einer ersten, zweiten und dritten Ausführungsform einer dritten Einheit zur Identifizierung und Signalisierung eines ungültigen Signalpegelwerts,
- Fig. 13: ein Zustandsdiagramm des erfindungsgemäßen Verfahrens zum Fixieren eines Verstärkungs- bzw. Dämpfungsfaktors eines Verstärkungs- oder Dämpfungsgliedes und
- Fig. 14: ein Flussdiagramm des erfindungsgemäßen Verfahrens zum Fixieren eines Verstärkungs- bzw. Dämpfungsfaktors eines Verstärkungs- oder Dämpfungsgliedes.

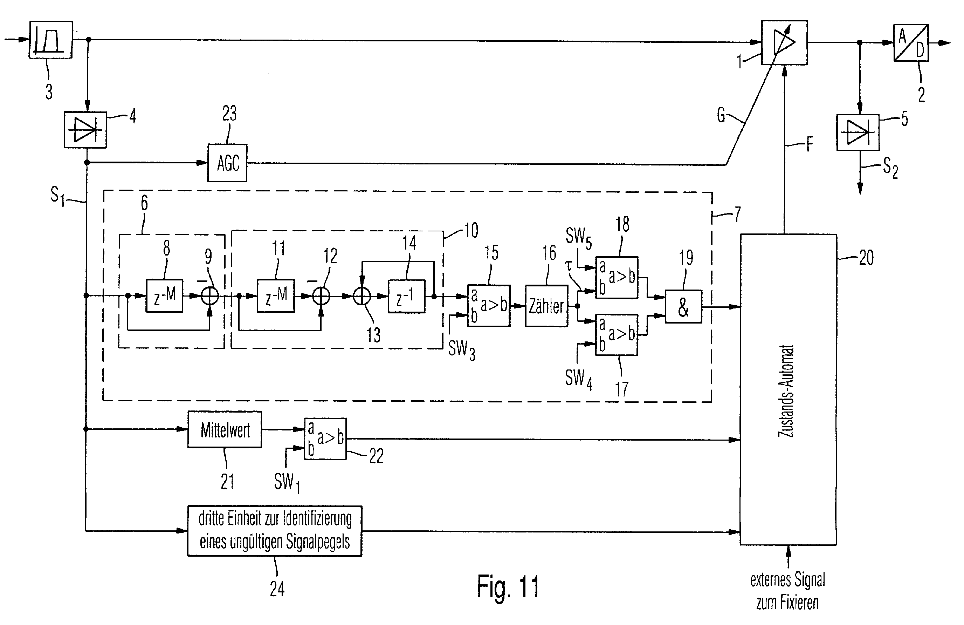

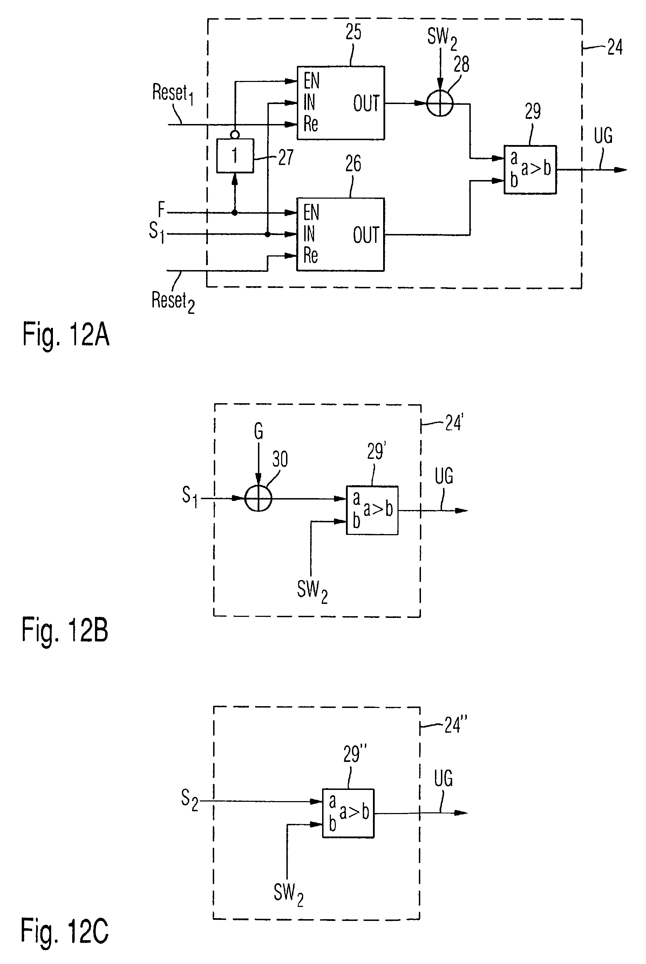

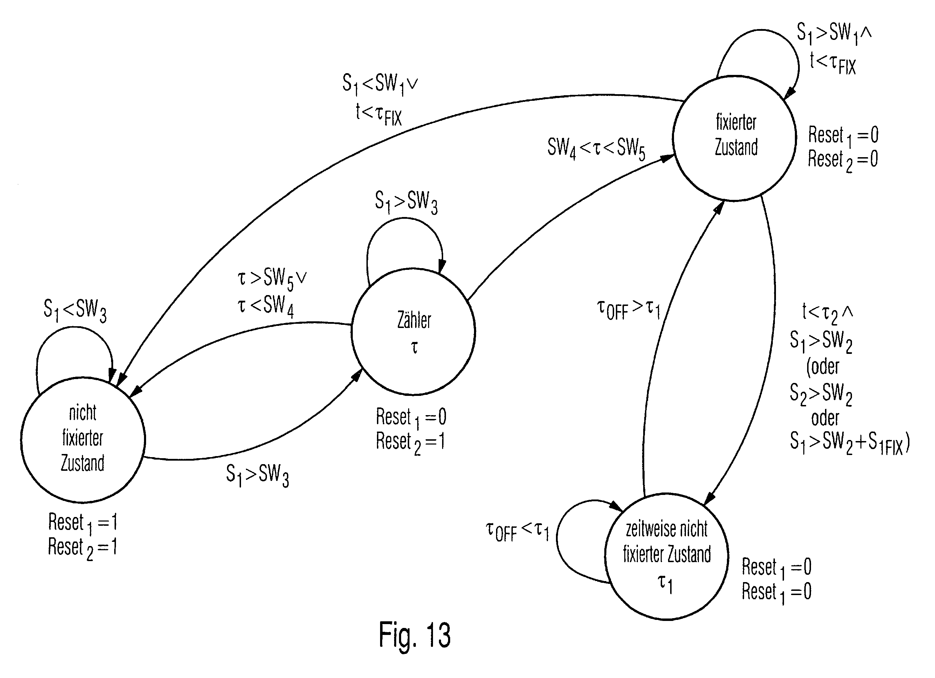

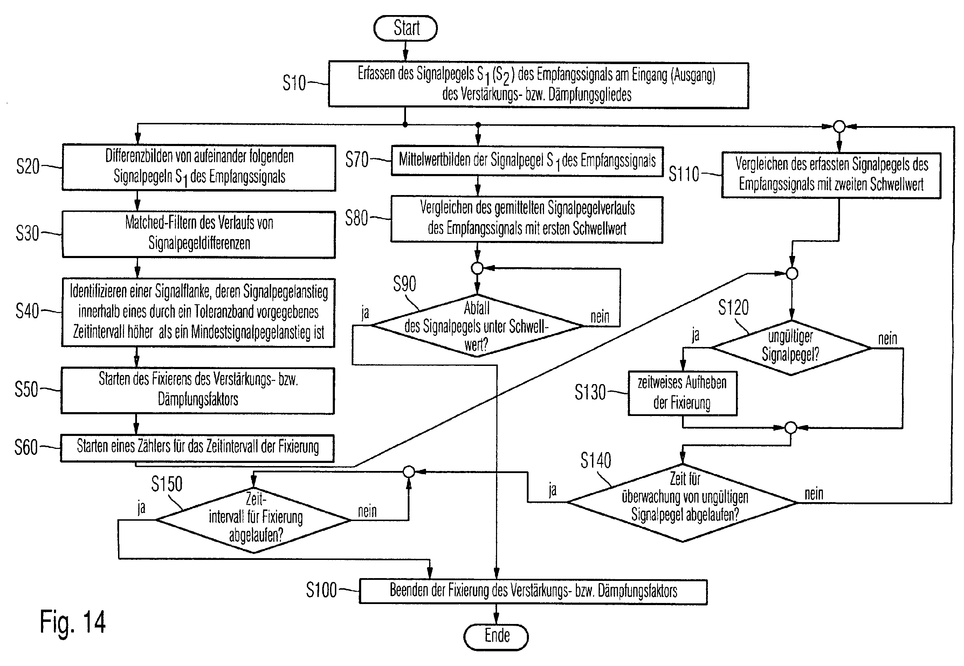

Im Folgenden werden das erfindungsgemäße Verfahren zum Fixieren eines Verstärkungs- bzw. Dämpfungsfaktors eines Verstärkungs- oder Dämpfungsgliedes anhand eines Flussdiagramms in Fig. 14 und die korrespondierende erfindungsgemäße Vorrichtung zum Fixieren eines Verstärkungs- bzw. Dämpfungsfaktors eines Verstärkungs- oder Dämpfungsgliedes anhand der Blockdiagramme in den Figuren 11, 12A, 12B und 12C und des Zustandsdiagramms in Fig. 13 im Detail erläutert.

Wie in Fig. 11 dargestellt, ist ein hinsichtlich seines Verstärkungsfaktors G einstellbares Verstärkungsglied 1 ausgangsseitig mit einer Signalverarbeitungseinheit verbunden - in Fig. 11 beispielsweise ein Analog-DigitalWandler 2 -, dessen Eingangsdynamik begrenzt ist und somit für die Einstellung des Verstärkungsfaktors G des Verstärkungsgliedes 1 von Relevanz ist. Eingangsseitig ist das Verstärkungsglied 1 mit einer weiteren Signalverarbeitungseinheit - in Fig. 11 beispielsweise ein als Bandpassfilter ausgeführtes Selektiv-Filter 3 - verbunden, dessen Ausgangsdynamik für die Einstellung des Verstärkungsfaktors G des Verstärkungsgliedes 1 nicht von Relevanz ist. Anstelle eines hinsichtlich seines Verstärkungsfaktors G einstellbaren Verstärkungsgliedes 1 kann auch ein hinsichtlich seines Dämpfungsfaktors ATT einstellbares Dämpfungsglied verwendet werden.

Im ersten Verfahrensschritt S10 in Fig. 14 wird in einem ersten Detektor 4 der Signalpegel S₁ des Empfangssignals am Eingang des Verstärkungsgliedes 1 und in einem zweiten Detektor 5 der Signalpegel S₂ des Empfangssignals am Ausgang des Verstärkungsgliedes 2 erfasst. Anstelle des Signalpegels des Empfangssignals kann alternativ auch der Leistungspegel des Empfangssignals in einem dafür geeigneten Detektor gemessen werden. In der folgenden Beschreibung wird von einer Messung des Signalpegels des Empfangssignals ausgegangen, wobei die Beschreibung auch für einen gemessenen Leistungspegel des Empfangssignals gilt. Auf der Basis des erfassen Signalpegels S₁ (S₂) des Empfangssignals wird in einer Einheit 23 zur automatischen Verstärkungsregelung (Automatic Gain Control (AGC)) der jeweils einzustellende Verstärkungsfaktors G für das Verstärkungsglied 1 (bzw. der jeweils einzustellende Dämpfungsfaktor ATT für das Dämpfungsglied) ermittelt.

Im nächsten Verfahrensschritt S20 werden in einem Differenzbildner 6, der zu einer ersten Einheit 7 gehört, in der der Übertragungsbeginn einer Sequenz von Synchronisationsdatensymbolen ermittelt wird, Differenzen von jeweils aufeinander folgenden Signalpegeln S₁ des vom ersten Detektor 4 am Eingang des Verstärkungsgliedes 1 gemessenen Empfangssignals ermittelt. Hierzu wird der am Eingang des Verstärkungsgliedes 1 gemessene Signalpegel des Empfangssignals mittels einer M-wertigen Verzögerungsstufe 8 um insgesamt M Abtastzyklen verzögert und anschließend in einem Subtrahierer 9 vom unverzögerten Signalpegel des Empfangssignals subtrahiert. Das Signal am Ausgang des Differenzbildners 6 stellt ein Maß für die Steigung einer im gemessenen Empfangssignal enthaltenen Signalflanke dar.

Im nächsten Verfahrensschritt S30 wird das Signal am Ausgang des Differenzbildners 6, das aus den Differenzen von jeweils aufeinander folgenden Signalpegeln S₁ des vom ersten Detektor 4 am Eingang des Verstärkungsgliedes 1 gemessenen Empfangssignals gebildet wird, einer Matched-Filterung in einem zur ersten Einheit 7 gehörigen Matched-Filter 10 zugeführt. Das Matched-Filter 10 besteht aus einem Differenzierglied mit einer M-wertigen Verzögerungsstufe 11 und mit einem Subtrahierer 12 und einem nachfolgenden Akkumulator mit einem Addierer 13 und mit einer Verzögerungsstufe 14. Durch die Matched-Filterung werden in den Signalpegel-Differenzen des Empfangssignals überlagerte Störsignalanteile gedämpft bzw. beseitigt. Hierbei handelt es sich hauptsächlich um überlagerte Rausch-Signalanteile oder überlagerte Übersprech-Signalanteile von Nachbarkanälen des im Funkgerät eingestellten Empfangskanals. Während das Differenzierglied des Matched-Filters 10 das Matched-Filterkriterium (Verzögerung um M Abtastzyklen) abbildet, führt der Akkumulator des Matched-Filters 10, der eine Tiefpass-Charakteristik aufweist, eine zusätzliche Dämpfung bzw. Beseitigung hochfrequenter Störsignalanteile durch.

Im nächsten Verfahrensschritt S40 wird endgültig der Übertragungsbeginn einer Sequenz von Synchronisationsdatensymbolen identifiziert. Hierzu wird der Matched-gefilterte Signalpegeldifferenzen-Verlauf in einem nachfolgenden dritten Vergleicher 15 gemäß Fig. 2 mit einem dritten Schwellwert SW₃ zum Ermitteln eines Signalpegelabschnitts des vom ersten Detektor 4 am Eingang des Verstärkungsgliedes 1 gemessenen Empfangssignals mit einer Signalflanke verglichen, deren Steigung oberhalb eines Mindestsignalpegelanstiegs liegt. Der Mindestsignalpegelanstieg wird durch Parametrierung des dritten Schwellwerts SW₃ festgelegt. Das Binärsignal am Ausgang des dritten Vergleichers 15 ist innerhalb des Signalabschnitts des Empfangssignals aktiviert, in dem eine Signalflanke mit einer gegenüber dem eingestellten Mindestsignalpegelanstieg höheren Steigung auftritt.

Die Zeitdauer τ dieses Signalabschnitts des Empfangssignals wird in einem nachfolgenden Zähler 16 durch Zählen der Abtastzyklen, die während eines aktivierten Ausgangssignals des dritten Vergleiches 15 auftreten, bestimmt. Die Zeitdauer τ des Signalabschnitts des Empfangssignals mit einer Signalflanke, deren Steigung oberhalb eines Mindestsignalpegelanstiegs liegt, wird gemäß Fig. 2 in einem nachfolgenden vierten Vergleicher 17 mit einem vierten Schwellwert SW₄ verglichen, der einen unteren Grenzwert eines Toleranzbereiches für die Zeitdauer τ des zu untersuchenden Signalabschnitts des Empfangssignals darstellt. Parallel wird die Zeitdauer τ des Empfangssignals mit einer Signalflanke, deren Steigung oberhalb eines Mindestsignalpegelanstiegs liegt, in einem nachfolgenden fünften Vergleicher 18 mit einem fünften Schwellwert SW₅ gemäß Fig. 2 verglichen, der einen oberen Grenzwert eines Toleranzbereiches für die Zeitdauer τ des zu untersuchenden Signalabschnitts des Empfangssignals darstellt.

Durch logisches UND-Verknüpfen des binären Ausgangssignals des vierten und fünften Vergleichers 17 und 18 in einem UND-Gatter 19 wird ermittelt, ob die Zeitdauer τ des Signalabschnitts des Empfangssignals mit einer Signalflanke, deren Steigung oberhalb eines Mindestsignalpegelanstiegs liegt, innerhalb des durch den festen und fünften Schwellwert SW₄ und SW₅ festgelegten Toleranzbereiches liegt. Ist dies der Fall, so liegt eine ansteigende Signalflanke einer Sequenz von Synchronisationsdatensymbolen vor.

Durch die Zeitverzögerung infolge der M-wertigen Verzögerung im Differenzbildner 6 und im Matched-Filter 10 und infolge der Akkumulation im Matched-Filter 10 und der Zählung im Zähler 16 ist der Zeitpunkt der Aktivierung des binären Ausgangssignals des UND-Gatters 19 gegenüber dem Zeitpunkt des Auftretens der Signalflanke der Sequenz von Synchronisationsdatensymbolen verzögert. Die Zeitverzögerung ist dabei so parametriert, dass die Aktivierung des binären Ausgangssignals des UND-Gatters 19 exakt auf den Übertragungsbeginn der Synchronisationsdatensymbole fällt, der gemäß Fig. 1 von der ansteigenden Signalflanke der Sequenz von Synchronisationsdatensymbolen um das Einstellintervall für den Verstärkungs- bzw. Dämpfungsfaktor verzögert ist.

Das Ausgangssignal des UND-Gatters 19 wird einer zweiten Einheit 20 zugeführt, die im Ausführungsbeispiel als Zustands-Automat realisiert ist und das Zeitintervall der Fixierung des Verstärkungsfaktors G des Verstärkungsgliedes 1 (bzw. des Dämpfungsfaktors ATT eines Dämpfungsgliedes) dem Verstärkungsglied 1 (bzw. dem Dämpfungsglied) über das Signal F signalisiert. Mit der Aktivierung des Ausgangssignals des UND-Gatters 19, die den Übertragungsbeginn der Synchronisationsdatensymbole kennzeichnet, wird im nächsten Verfahrensschritt S50 die Fixierung des Verstärkungsfaktors G des Verstärkungsgliedes 1 (bzw. des Dämpfungsfaktors ATT eines Dämpfungsgliedes) dem Verstärkungsglied 1 (bzw. dem Dämpfungsglied) über das aktivierte Signal F gemäß Fig. 3 gestartet.

Mit dem Start der Fixierung des Verstärkungsfaktors G des Verstärkungsgliedes 1 (bzw. des Dämpfungsfaktors ATT eines Dämpfungsgliedes) wird im nächsten Verfahrensschritt S60 ein in der zweiten Einheit 20 integriertes Zeitglied gestartet, das den Ablauf der Zeitdauer τ*_{Fix}* des Zeitintervalls der Fixierung anzeigt.

Parallel zur Identifizierung des Übertragungsbeginns der Sequenz von Synchronisationsdatensymbolen gemäß der Verfahrensschritte S10 bis S40 wird im Verfahrensschritt S70 in einem Mittelwertbildner 21 der Mittelwert einer Folge von Signalpegeln des vom ersten Detektor 4 am Eingang des Verstärkungsgliedes 1 gemessenen Empfangssignals über ein geeignete parametriertes Mittelungsintervall bestimmt.

Im darauf folgenden Verfahrensschritt S80 wird die gemittelte Signalpegelfolge des Empfangssignals in einem nachfolgenden ersten Vergleicher 22 mit einem ersten Schwellwert SW₁ verglichen.

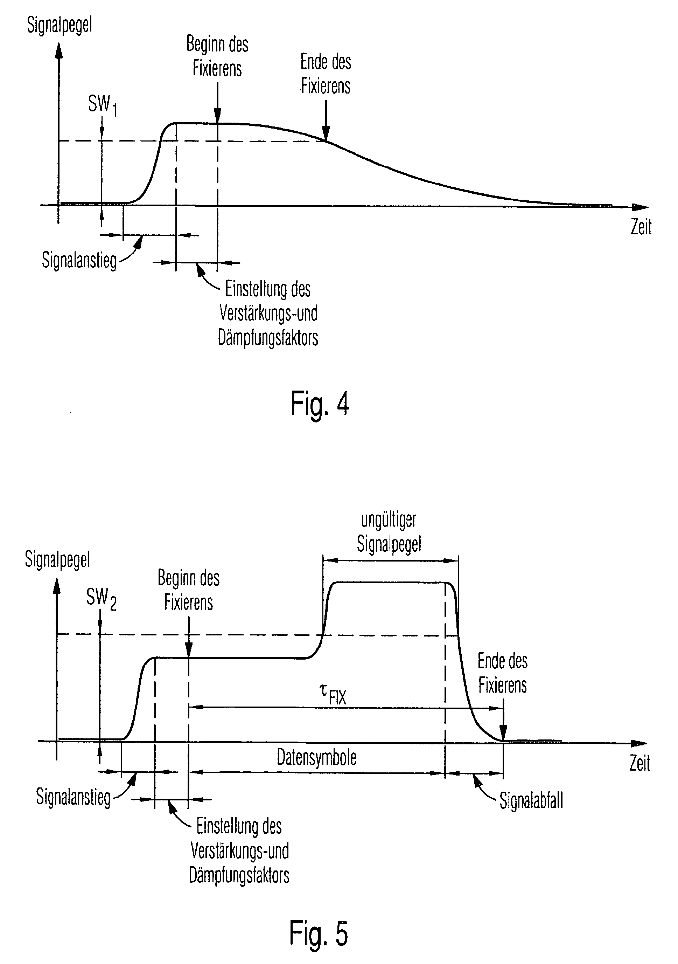

Wird im nächsten Verfahrensschritt S90 gemäß Fig. 4 ein Unterschreiten des ersten Schwellwerts SW₁ durch die gemittelte Signalpegelfolge des Empfangssignals identifiziert, so ist eine weitere Fixierung des Verstärkungsfaktors G des Verstärkungsgliedes 1 (bzw. des Dämpfungsfaktors ATT eines Dämpfungsgliedes) nicht mehr von Relevanz. Durch die Mittelung der Signalpegelfolge des Empfangssignals wird vermieden, dass durch einen kurzzeitigen Abfall des Signalpegels des Empfangssignals eine vorzeitige Beendigung der Fixierung des Verstärkungsfaktors G des Verstärkungsgliedes 1 (bzw. des Dämpfungsfaktors ATT eines Dämpfungsgliedes) stattfindet. Das Unterschreiten des ersten Schwellwerts SW₁ durch die gemittelte Signalpegelfolge des Empfangssignals wird vom ersten Vergleicher 22 der zweiten Einheit 20 signalisiert, die wiederum gemäß Verfahrensschritt S100 dem Verstärkungsglied 1 (bzw. dem Dämpfungsglied) die Beendigung der Fixierung des Verstärkungsfaktors G des Verstärkungsgliedes 1 (bzw. des Dämpfungsfaktors ATT eines Dämpfungsgliedes) durch Deaktivieren des Fixierungssignals F signalisiert.

Ebenfalls parallel zur Identifizierung des Übertragungsbeginns des Sequenz von Synchronisationsdatensymbolen gemäß der Verfahrensschritte S10 bis S40 und parallel zur Identifizierung einer vorzeitig zu beendenden Fixierung des Verstärkungsfaktors G bzw. des Dämpfungsfaktors ATT für das Verstärkungsglied 1 bzw. für das Dämpfungsgliedes gemäß der Verfahrensschritte S70 bis S90 wird in einem Verfahrensschritt S110 in einer dritten Einheit 24 ein ungültiger Signalpegel des Empfangssignals untersucht, der gemäß Fig. 5 durch ein Überschreiten eines zweiten Schwellwerts SW₂ gekennzeichnet ist.

In einer ersten Ausführungsform einer dritten Einheit 24, die einen ungültigen Signalpegel des Empfangssignals identifiziert, sind gemäß Fig. 12A eine erste Speichereinheit 25 und eine zweite Speichereinheit 26 vorgesehen. Sowohl der ersten Speichereinheit 25 als auch der zweiten Speichereinheit 26 wird das vom ersten Detektor 4 am Eingang des Verstärkungsgliedes 1 erfasste Empfangssignal zur Speicherung zugeführt. Während die erste Speichereinheit 25 durch das im Invertierer 27 invertierte Signal F zum Fixieren des Verstärkungs- bzw. Dämpfungsfaktors des Verstärkungs- oder Dämpfungsgliedes beaufschlagt wird, wird die zweite Speichereinheit 26 durch das nicht-invertierte Signal F zum Fixieren des Verstärkungs- bzw. Dämpfungsfaktors des Verstärkungs- oder Dämpfungsgliedes versorgt.

Durch ein aktiviertes Signal F zum Fixieren des Verstärkungs- bzw. Dämpfungsfaktors des Verstärkungs- oder Dämpfungsgliedes wird der Ausgang OUT der zweiten Speichereinheit 26 mit dem am Eingang IN der zweiten Speichereinheit 26 anliegenden Signalpegel des Empfangssignals aktualisiert, während durch ein invertierte aktivierte Signal F zum Fixieren des Verstärkungs- bzw. Dämpfungsfaktors des Verstärkungs- oder Dämpfungsgliedes der im Zeitpunkt des Übergangs vom nicht-aktivierten in den aktivierten Zustand des Signals F zum Fixieren des Verstärkungs- bzw. Dämpfungsfaktors des Verstärkungs- oder Dämpfungsgliedes am Eingang IN der ersten Speichereinheit 25 anliegende Signalpegel des Empfangssignals an den Ausgang OUT der ersten Speichereinheit 25 transferiert und bis zu einer Änderung des Signals F zum Fixieren des Verstärkungs- bzw. Dämpfungsfaktor des Verstärkungs- oder Dämpfungsgliedes vom aktivierten in den nicht-aktivierten Zustand gehalten wird.

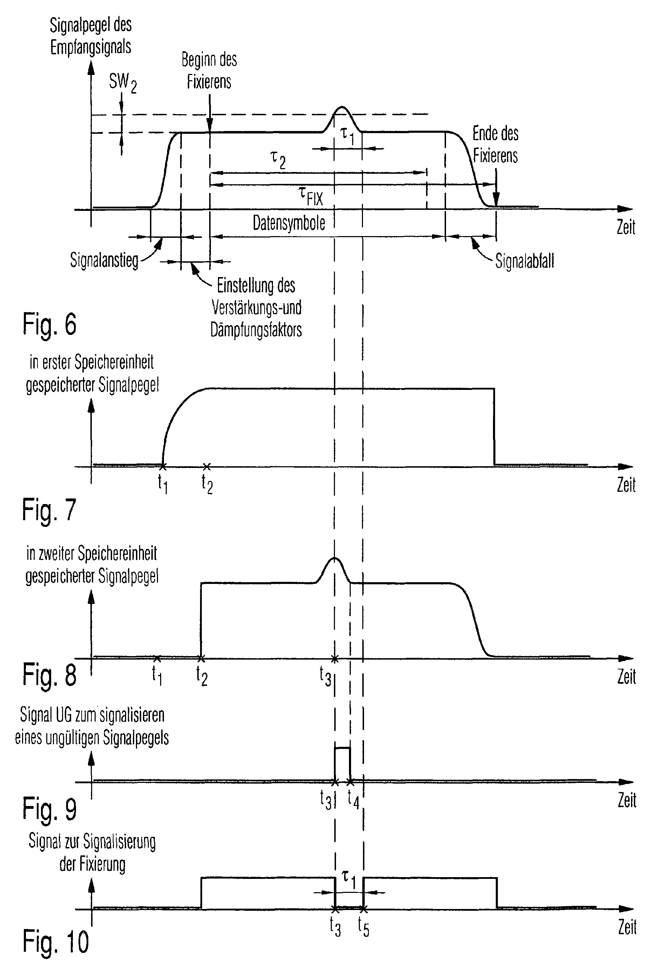

Mit Deaktivierung der Reset-Eingänge Reset₁ der ersten Speichereinheit 25 bei Überschreitung des dritten Schwellwerts SW₃ durch den Signalpegel des vom ersten Detektor 4 am Eingang des Verstärkungsgliedes 1 erfassten Empfangssignals - Zeitpunkt t₁ in Fig. 7 - kann der Ausgang OUT der ersten Speichereinheit 25 mit einem neuen Wert belegt werden. Ab diesem Zeitpunkt t₁ ist der Freigabe-Eingang EN der ersten Speichereinheit 25 aufgrund des noch nicht aktivierten Signals F zum Fixieren des Verstärkungs- bzw. Dämpfungsfaktors des Verstärkungs- oder Dämpfungsgliedes aktiviert und somit wird der Ausgang OUT der ersten Speichereinheit 25 gemäß Fig. 7 ständig mit den Signalpegelwerten des Empfangssignals am Eingang IN der ersten Speichereinheit 25 aktualisiert. Mit Aktivierung des Signals F zum Fixieren des Verstärkungs- bzw. Dämpfungsfaktors des Verstärkungs- oder Dämpfungsgliedes ab dem Zeitpunkt t₂ hält die erste Speichereinheit 25 an ihrem Ausgang OUT den an ihrem Eingang IN zum Zeitpunkt t₂ anliegenden Signalpegelwert des Empfangssignals gemäß Fig. 7 fest, während der Ausgang OUT der ersten Speichereinheit 25 ab dem Zeitpunkt t₂, in dem der zugehörige Reset-Eingang Reset₂ deaktiviert wird und damit ein Belegen des Ausgangs der zweiten Speichereinheit 26 mit Werten freigeschaltet wird, ständig mit dem am Eingang IN anliegenden Signalpegelwerten des Empfangssignals gemäß Fig. 8 aktualisiert wird.

In einem der ersten Speichereinheit 25 nachfolgenden Addierer 28 wird zum am Ausgang OUT der ersten Speichereinheit 25 gespeicherten Signalpegel des Empfangssignals der zweite Schwellwert SW₂ addiert. In einem dem Addierer 28 und der zweiten Speichereinheit 26 nachfolgenden zweiten Vergleicher 29 wird der am Ausgang OUT der ersten Speichereinheit 25 im Zeitpunkt der Fixierung des Verstärkungs- bzw. Dämpfungsfaktors des Verstärkungs- oder Dämpfungsgliedes - das heißt im Zeitpunkt des Übertragungsbeginns der Synchronisationsdatensymbolen - gehaltene und um den zweiten Schwellwert erhöhte Signalpegel des Empfangssignals mit dem am Ausgang OUT der zweiten Speichereinheit 26 ab dem Zeitpunkt die Fixierung des Verstärkungs- bzw. Dämpfungsfaktors des Verstärkungs- oder Dämpfungsgliedes ständig aktualisierten Signalpegel des Empfangssignals verglichen.

Falls der am Ausgang OUT der zweiten Speichereinheit 26 ständig aktualisierte Signalpegel des Empfangssignals die Summe aus dem am Ausgang OUT der ersten Speichereinheit 25 gehaltenen Signalpegel des Empfangssignals und dem zweiten Schwellwert im Zeitpunkt t₃ gemäß Fig. 8 überschreitet, liegt ein ungültiger Signalpegel des Empfangssignals vor. Dies wird der zweiten Einheit 20 von der dritten Einheit 24 durch ein Signal UG zum Signalisieren eines ungültigen Signalpegels gemäß Fig. 9 signalisiert. Gemäß Fig. 9 ist dieses Signal UG zum Signalisieren eines ungültigen Signalpegels bis zum Zeitpunkt t₄ aktiviert, in dem der am Ausgang OUT der zweiten Speichereinheit 26 ständig aktualisierte Signalpegel des Empfangssignals den Summenwert aus dem im Ausgang OUT der ersten Speichereinheit 26 angehaltenen Signalpegel des Empfangssignals und dem zweiten Schwellwert SW₂ unterschreitet.

Mittels der in Fig. 12A dargestellten dritten Einheit 24 zur Identifizierung eines ungültigen Signalpegels wird ein ungültiger Signalpegel des Empfangssignals identifiziert, sobald der Signalpegel des Empfangssignals einen Schwellwert überschreitet, der durch den Signalpegel des Empfangssignals während der Fixierung des Verstärkungs- bzw. Dämpfungsfaktors des Verstärkungs- oder Dämpfungsgliedes zuzüglich eines zweiten Schwellwerts SW₂ festgelegt ist.

In einer zweiten Ausführungsform einer dritten Einheit 24' zur Identifizierung eines ungültigen Signalpegels gemäß Fig. 12B wird der Signalpegel S₁ des vom ersten Detektor 4 am Eingang des Verstärkungsgliedes erfassten Empfangssignals in einem Multiplizierer 30 mit dem im Verstärkungsglied 1 (bzw. Dämpfungsglied) eingestellten Verstärkungsfaktor G (bzw. Dämpfungsfaktor ATT) multipliziert und der mit dem Verstärkungsfaktor G (bzw. Dämpfungsfaktor ATT) gewichtete Signalpegel S₁ des vom ersten Detektor 4 am Eingang des Verstärkungsgliedes 1 (bzw. Dämpfungsgliedes) erfassten Empfangssignals in einem nachfolgenden zweiten Vergleicher 29' mit einem zweiten Schwellwert SW₂ verglichen. Überschreitet der mit dem Verstärkungsfaktor G (bzw. mit dem Dämpfungsfaktor ATT) gewichtete Signalpegel des vom ersten Detektor 4 am Eingang des Verstärkungsgliedes 1 (bzw. Dämpfungsgliedes) erfassen Empfangssignals den zweiten Schwellwert SW₂, so liegt ein ungültiger Signalpegel des Empfangssignals vor, der der zweiten Einheit 20 mit dem am Ausgang des zweiten Vergleiches 29' erzeugten Signals UG zum Signalisieren eines ungültigen Signalpegels signalisiert wird.

In einer dritten Ausführungsform einer dritten Einheit 24" zur Identifizierung eines ungültigen Signalpegels gemäß Fig. 12C wird der Signalpegel S₂ des vom zweiten Detektor 5 am Ausgang des Verstärkungsgliedes erfassten Empfangssignals in einem zweiten Vergleicher 29" mit einem zweiten Schwellwert SW₂ verglichen. Überschreitet der vom zweiten Detektor 5 am Ausgang des Verstärkungsgliedes erfasste Signalpegel des Empfangssignals den zweiten Schwellwert SW₂, so liegt ein ungültiger Signalpegel des Empfangssignals vor, der der zweiten Einheit 20 dem am Ausgang des zweiten Vergleichers 29" erzeugten Signals UG zum Signalisieren eines ungültigen Signalpegels signalisiert wird.

Wird im nächsten Verfahrensschritt S120 in Fig. 14 ein ungültiger Signalpegel des Empfangssignals durch Aktivierung des Signals UG zum Signalisieren eines ungültigen Signalpegels durch die dritte Einheit 24, 24' oder 24" identifiziert, so wird das Fixieren des Verstärkungs- bzw. Dämpfungsfaktors des Verstärkungs- oder Dämpfungsgliedes zeitweise für eine erste Zeitdauer τ₁ zwischen den Zeitpunkten t₃ und t₅ gemäß Fig. 6 und Fig. 10 im darauf folgenden Verfahrensschritt S130 aufgehoben. In dieser ersten Zeitdauer τ₁ kann die automatische Verstärkungsregelung 23 den Verstärkungsfaktor G (bzw. den Dämpfungsfaktor ATT) des Verstärkungsgliedes 1 (bzw. des Dämpfungsgliedes) nachregeln. Auf diese Weise reduziert sich der Signalpegel des Empfangssignals gemäß Fig. 6 auf den Wert, den er während der Fixierung des Verstärkungs- bzw. Dämpfungsfaktors des Verstärkungs- oder Dämpfungsgliedes besaß. Reduziert sich der Signalpegel des Empfangssignals wieder auf einen Wert unterhalb des zweitens Schwellwerts SW₂, so wird das Signal UG zum Signalisieren eines ungültigen Signalpegels am Ausgang der dritten Einheit 24, 24' bzw. 24" zum Signalisieren eines ungültigen Signalpegels im Zeitpunkt t₄ gemäß Fig. 9 wieder deaktiviert.

Die Überwachung des Signalpegels des Empfangssignals mittels des zweiten Schwellwerts SW₂ zur Identifizierung eines ungültigen Signalpegels erfolgt einzig in einer zweiten Zeitdauer τ₂, die gegenüber der Zeitdauer τ*_{Fix}* des Fixierens des Verstärkungs- bzw. Dämpfungsfaktors des Verstärkungs- oder Dämpfungsgliedes reduziert ist. Ist der Ablauf der Zeitdauer τ₂, die gemäß Fig. 6 mit dem Beginn des Fixierens des Verstärkungs- bzw. Dämpfungsfaktors des Verstärkungs- oder Dämpfungsgliedes und damit mit dem Übertragungsbeginn der Synchronisationsdatensymbole gestartet wird, im nächsten Verfahrensschritt S140 der Fig. 14 identifiziert worden, so wird im darauf folgenden Verfahrensschritt S150 der Ablauf des Zeitintervalls τ*_{Fix}* zum Fixieren des Verstärkungs- bzw. Dämpfungsfaktors des Verstärkungs- oder Dämpfungsgliedes überwacht. Ist die Zeitdauer τ₂ dagegen noch nicht abgelaufen, so wird gemäß Verfahrensschritt S110 der erfasste Signalpegel des Empfangssignals weiterhin mit dem zweiten Schwellwert SW₂ im Hinblick auf die Identifizierung eines ungültigen Signalpegels verglichen.

Nach Ablauf des Zeitintervalls τ*_{Fix}* zum Fixieren des Verstärkungs- bzw. Dämpfungsfaktors des Verstärkungs- oder Dämpfungsgliedes wird die Fixierung des Verstärkungs- bzw. Dämpfungsfaktors des Verstärkungs- oder Dämpfungsgliedes gemäß Verfahrensschritt S100 beendet.

Aus Fig. 13 geht das Zustandsdiagramm des Zustandsautomaten der zweiten Einheit 20 hervor, die dem Verstärkungsglied 1 (bzw. dem Dämpfungsglied) das Zeitintervall des Fixierens des Verstärkungs- bzw. Dämpfungsfaktors des Verstärkungs- oder Dämpfungsgliedes signalisiert. Zu erkennen sind die vier Zustände:
- nichtfixierter Zustand,
- Zustand, in dem der Zähler 16 der ersten Einheit 7 aktiv ist,
- fixierter Zustand und
- zeitweise nicht fixierter Zustand
sowie die Bedingungen für eine mögliche Transition zwischen den einzelnen Zuständen und für ein Verweilen im jeweiligen Zustand.

Die Erfindung ist nicht auf die dargestellten Ausführungsformen des erfindungsgemäßen Verfahrens und der erfindungsgemäßen Vorrichtung beschränkt. Von der Erfindung sind insbesondere alle möglichen Kombinationen der in den Figuren dargestellten Merkmale, der in der Beschreibung beschriebenen Merkmale und der in den Ansprüchen beanspruchten Merkmale mit abgedeckt.

## Patentansprüche

1. Verfahren zum Fixieren eines Verstärkungs- bzw. Dämpfungsfaktors (G;ATT) für ein Verstärkungs- oder Dämpfungsglied (1) während einer Übertragung einer Sequenz von Synchronisationsdatensymbolen mit folgenden Verfahrensschritten:
• Erfassen eines Signalpegels (S₁) eines Empfangssignals am Eingang des Verstärkungs- oder Dämpfungsglieds (1),
• Identifizieren eines Übertragungsbeginns (t₂) der Sequenz von Synchronisationsdatensymbolen anhand des erfassten Signalpegels (S₁) des Empfangssignals und
• Signalisieren eines mit dem identifizierten Übertragungsbeginn (t₂) der Sequenz von Synchronisationsdatensymbolen beginnenden Zeitintervalls des Fixierens des Verstärkungs- bzw. Dämpfungsfaktors (G;ATT),
wobei eine seit dem Beginn (t₂) des Zeitintervalls des Fixierens des Verstärkungs- bzw. Dämpfungsfaktors (G;ATT) ermittelte Signalpegeldifferenz des am Eingang des Verstärkungs- bzw. Dämpfungsgliedes (1) erfassten Empfangssignals (S₁) mit einem zweiten Schwellwert (SW₂) zur Identifizierung eines ungültigen Signalpegels verglichen wird und das Fixieren des Verstärkungs- bzw. Dämpfungsfaktors (G;ATT) für eine festgelegte erste Zeitdauer (τ₁) aufgehoben wird, sobald die ermittelte Signalpegeldifferenz den zweiten Schwellwert (SW₂) überschreitet.

2. Verfahren nach Anspruch 1,
**dadurch gekennzeichnet,**
**dass** das Zeitintervall des Fixierens des Verstärkungs- bzw. Dämpfungsfaktors (G;ATT) spätestens nach einer Übertragungsdauer (τ*_{Fix}*) für die Sequenz von Synchronisationsdatensymbolen beendet ist.

3. Verfahren nach Anspruch 1 und 2,
**dadurch gekennzeichnet,**
**dass** der erfasste Signalpegel (S₁) des Empfangssignals über ein bestimmtes Mittelungsintervall gemittelt und mit einem ersten Schwellwert (SW₁) zur Identifizierung eines vorzeitig beendeten Fixierens verglichen wird und das Zeitintervall des Fixierens des Verstärkungs- bzw. Dämpfungsfaktors vorzeitig beendet wird, falls der gemittelte Signalpegel des Empfangssignals den ersten Schwellwert (SW₁) unterschreitet.

4. Verfahren nach einem der Ansprüche 1 bis 3,
**dadurch gekennzeichnet,**
**dass** seit dem Beginn (t₂) des Zeitintervalls des Fixierens des Verstärkungs- bzw. Dämpfungsfaktors (G;ATT) der mit dem fixierten Verstärkungs- bzw. Dämpfungsfaktor (G;ATT) multiplizierte und am Eingang des Verstärkungs- bzw. Dämpfungsgliedes (1) erfasste Signalpegel (S₁) des Empfangssignals mit dem zweiten Schwellwert (SW₂) zur Identifizierung eines ungültigen Signalpegels verglichen wird und das Fixieren des Verstärkungs- bzw. Dämpfungsfaktors (G;ATT) für eine festgelegte erste Zeitdauer (τ₁) aufgehoben wird, sobald der mit dem fixierten Verstärkungs- bzw. Dämpfungsfaktor (G;ATT) multiplizierte Signalpegel (S₁) des Empfangssignals den zweiten Schwellwert (SW₂) überschreitet.

5. Verfahren nach einem der Ansprüche 1 bis 3,
**dadurch gekennzeichnet,**
**dass** seit dem Beginn (t₂) des Zeitintervalls des Fixierens des Verstärkungs- bzw. Dämpfungsfaktors (G;ATT) ein am Ausgang des Verstärkungs- bzw. Dämpfungsgliedes (1) erfasster Signalpegel (S₂) des Empfangssignals mit dem zweiten Schwellwert (SW₂) zur Identifizierung eines ungültigen Signalpegels verglichen wird und das Fixieren des Verstärkungs- bzw. Dämpfungsfaktors (G;ATT) für eine festgelegte erste Zeitdauer (τ₁) aufgehoben wird, sobald der erfasste Signalpegel (S₂) des Empfangssignals den zweiten Schwellwert (SW₂) überschreitet.

6. Verfahren nach einem der Ansprüche 1 bis 5,
**dadurch gekennzeichnet,**
**dass** der Vergleich des erfassten Signalpegels (S₁;S₂) des Empfangssignals mit dem zweiten Schwellwert (SW₂) auf eine zweite Zeitdauer (τ₂) begrenzt ist, die gegenüber der Übertragungsdauer (τ*_{Fix}*) für die Sequenz von Synchronisationsdatensymbolen reduziert ist.

7. Verfahren nach einem der Ansprüche 1 bis 6,
**dadurch gekennzeichnet,**
**dass** das Identifizieren des Übertragungsbeginns (t₂) der Sequenz von Synchronisationsdatensymbolen folgende Verfahrensschritte beinhaltet:
• Differenzbilden von jeweils aufeinander folgenden Signalpegeln (S₁) des Empfangssignals,
• Vergleichen des Verlaufs von Differenzen von aufeinander folgenden Signalpegeln (S₁) des Empfangssignals mit einem dritten Schwellwert (SW₃) zur Bestimmung eines Zeitintervalls (τ) mit einem gegenüber einem Mindestsignalpegelanstieg größeren Signalpegelanstieg des Empfangssignals und
• Identifizieren des Übertragungsbeginns (t₂) der Sequenz von Synchronisationsdatensymbolen, sobald das Zeitintervall (τ) mit einem gegenüber dem Mindestsignalpegelanstieg größeren Signalpegelanstieg des Empfangssignals zwischen einem vierten und fünften Schwellwert (SW₄, SW₅) liegt, der den unteren bzw. oberen Grenzwert für das Zeitintervall (τ) mit einem gegenüber dem Mindestsignalpegelanstieg größeren Signalpegelanstieg des Empfangssignals festlegt.

8. Verfahren nach Anspruch 5,
**dadurch gekennzeichnet,**
**dass** nach dem Differenzbilden ein Matched-Filtern der jeweils gebildeten Differenzen durchgeführt wird.

9. Vorrichtung zum Fixieren eines Verstärkungs- bzw. Dämpfungsfaktors (G;ATT) für ein Verstärkungs- oder Dämpfungsglied (1) während einer Übertragung einer Sequenz von Synchronisationsdatensymbolen mit
einem ersten Detektor (4) zum Erfassen eines Signalpegels (S₁) eines Empfangssignals am Eingang des Verstärkungs- oder Dämpfungsglieds (1),
einer nachgeschalteten ersten Einheit (7), die einen Übertragungsbeginn (t₂) der Sequenz von Synchronisationsdatensymbolen ermittelt, und
einer nachgeschalteten zweiten Einheit (20), die dem Verstärkungs- oder Dämpfungsglied (1) ein Zeitintervall des Fixierens des Verstärkungs- bzw. Dämpfungsfaktors (G;ATT) signalisiert,
wobei der zweiten Einheit (20) eine dritte Einheit (24;24';24") vorgeschaltet ist, die einen ungültigen Signalpegel identifiziert, anhand einer Signalpegeldifferenz zwischen dem Signalpegel (S₁) und einem zweiten Schwellwert (SW₂), und ein zeitweises Aufheben des Fixierens signalisiert, wobei das Fixieren für eine festgelegte erste Zeitdauer aufgehoben wird.

10. Vorrichtung nach Anspruch 9,
**dadurch gekennzeichnet,**
**dass** zusätzlich ein Mittelwertbildner (21) zur Ermittlung des Mittelwerts des am Eingang des Verstärkungs- oder Dämpfungsglieds (1) erfassten Signalpegels (S₁) des Empfangssignals und ein zwischen dem Mittelwertbildner (6) und der zweiten Einheit (20) geschalteter erster Vergleicher (22) zum Identifizieren und Signalisieren eines vorzeitig beendeten Fixierens vorgesehen sind.

11. Vorrichtung nach Anspruch 9,
**dadurch gekennzeichnet,**
**dass** die dritte Einheit (24) dem ersten Detektor (4) nachgeschaltet ist und eine erste Speichereinheit (25) zum Speichern des zum Übertragungsbeginn (t₂) der Sequenz von Synchronisationsdatensymbolen vom ersten Detektor (4) erfassten Signalpegels (S₁), eine zweite Speichereinheit (26) zum Speichern des aktuell vom ersten Detektor (4) erfassten Signalpegels (S₁), ein Addierer (28) zum Addieren des in der ersten Speichereinheit (25) gespeicherten Signalpegels und eines zweiten Schwellwerts (SW₂) und ein zweiter Vergleicher (29) zum Signalisieren des zeitweisen Aufhebens des Fixierens bei Überschreiten des in der ersten Speichereinheit (25) gespeicherten Signalpegels und des zweiten Schwellwerts (SW₂) durch den in der zweiten Speichereinheit (26) gespeicherten Signalpegel aufweist.

12. Vorrichtung nach Anspruch 9,
**dadurch gekennzeichnet,**
**dass** die dritte Einheit (24') dem ersten Detektor (4) nachgeschaltet ist und einen Multiplizierer (30) zum Gewichten des vom ersten Detektor (4) erfassten Signalpegels (S₁) des Empfangssignals mit dem Verstärkungs- bzw. Dämpfungsfaktor (G;ATT) des Verstärkungs- oder Dämpfungsglieds (1) und einen nachgeschalteten zweiten Vergleicher (29') zum Signalisieren des zeitweisen Aufhebens des Fixierens bei Überschreiten eines zweiten Schwellwerts (SW₂) durch den gewichteten Signalpegel des vom ersten Detektor (4) erfassten Empfangssignals aufweist.

13. Vorrichtung nach Anspruch 9,
**dadurch gekennzeichnet,**
**dass** die dritte Einheit (24") einem zweiten Detektor (5) zum Erfassen eines Signalpegels (S₂) eines Empfangssignals am Ausgang des Verstärkungs- oder Dämpfungsglieds (1) nachgeschaltet ist und einen nachgeschalteten zweiten Vergleicher (29") zum Signalisieren des zeitweisen Aufhebens des Fixierens bei Überschreiten eines zweiten Schwellwerts (SW₂) durch den vom zweiten Detektor (5) erfassten Signalpegel (S₂) des Empfangssignals aufweist.

14. Vorrichtung nach einem der Ansprüche 9 bis 13,
**dadurch gekennzeichnet,**
**dass** die erste Einheit (7) einen Differenzbildner (6) zum Bilden von Differenzen von Signalpegeln (S₁) des Empfangssignals, einen dritten Vergleicher (15) zum Bestimmen eines Zeitintervalls (τ) mit einem gegenüber einem Mindestsignalpegelanstieg größeren Signalpegelanstieg des Empfangssignals, einen vierten bzw. fünften Vergleicher (17,18) zum Identifizieren und Signalisieren des Übertragungsbeginns (t₂) der Sequenz von Synchronisationsdatensymbolen bei einem zwischen dem vierten und fünften Schwellwert (SW₄,SW₅) liegenden Zeitintervall (τ) mit einem gegenüber dem Mindestsignalpegelanstieg größeren Signalpegelanstieg des Empfangssignals aufweist.

15. Vorrichtung nach Anspruch 14,
**dadurch gekennzeichnet,**
**dass** zwischen dem Differenzbildner (6) und dem dritten Vergleicher (15) ein Matched-Filter (10) geschaltet ist.

16. Computerprogramm mit Programmcode-Mitteln, um alle Schritte gemäß einem der Ansprüche 1 bis 8 durchführen zu können, wenn das Programm auf einem Computer oder einem digitalen Signalprozessor ausgeführt wird.

17. Computerprogramm-Produkt mit insbesondere auf einem maschinenlesbaren Träger gespeicherten Programmcode-Mitteln, um alle Schritte gemäß einem der Ansprüche 1 bis 8 durchführen zu können, wenn das Programm auf einem Computer oder einem digitalen Signalprozessor ausgeführt wird.

## Claims

1. Method for fixing a gain or attenuation factor (G; ATT) for an amplifying or attenuating element (1) during transmission of a sequence of synchronisation data symbols with the following method steps:
- detection of a signal level (S₁) of a received signal at the input of the amplifying or attenuating element (1),
- identification of a beginning of transmission (t₂) of the sequence of synchronisation data symbols on the basis of the detected signal level (S₁) of the received signal and
- signalling of a time interval for the fixing of the gain or attenuation factor (G; ATT) beginning with the identified beginning of transmission (t₂) of the sequence of synchronisation data symbols,
wherein a difference in the signal level of the received signal (S₁) detected at the input of the amplifying or attenuating element (1) determined from the beginning (t₂) of the time interval for fixing the gain or attenuation factor (G; ATT) is compared with a second threshold value (SW₂) in order to identify an invalid signal level, and the fixing of the gain or attenuation factor (G; ATT) is cancelled for a set first period of time (τ*₁*) as soon as the determined difference in the signal level exceeds the second threshold value (SW₂).

2. Method according to claim 1,
**characterised in that**
the time interval for the fixing of the gain or attenuation factor (G; ATT) is ended at the latest after a period of transmission (τ_{Fix}) for the sequence of synchronisation data symbols.

3. Method according to claim 1 and 2,
**characterised in that**
the detected signal level (S₁) of the received signal is averaged over a given averaging interval and compared with a first threshold value (SW₁) in order to identify a prematurely ended fixing, and the time interval for the fixing of the gain or attenuation factor is ended prematurely if the averaged signal level of the received signal falls below the first threshold value (SW₁).

4. Method according to one of claims 1 to 3,
**characterised in that**
from the beginning (t₂) of the time interval for the fixing of the gain or attenuation factor (G; ATT) the signal level (S₁) of the received signal multiplied with the fixed gain or attenuation factor (G; ATT) and detected at the input of the amplifying or attenuating element (1) is compared with the second threshold value (SW₂) in order to identify an invalid signal level, and the fixing of the gain or attenuation factor (G; ATT) is cancelled for a set first period of time (τ*₁*) as soon as the signal level (S₁) of the received signal multiplied with the fixed gain or attenuation factor (G; ATT) exceeds the second threshold value (SW₂).

5. Method according to one of claims 1 to 3,
**characterised in that**,
from the beginning (t₂) of the time interval for the fixing of the gain or attenuation factor (G; ATT), a signal level (S₂) of the received signal detected at the output of the amplifying or attenuating element (1) is compared with the second threshold value (SW₂) in order to identify an invalid signal level, and the fixing of the gain or attenuation factor (G; ATT) is cancelled for a set first period of time (τ*₁*) as soon as the detected signal level (S₂) of the received signal exceeds the second threshold value ((SW₂).

6. Method according to one of claims 1 to 5,
**characterised in that**,
the comparison of the detected signal level (S₁; S₂) of the received signal with the second threshold value (SW₂) is limited to a second period of time (τ*₂*) which is reduced by comparison with the period of transmission (τ*_{Fix}*) for the sequence of synchronisation data symbols.

7. Method according to one of claims 1 to 6,
**characterised in that**
the identification of the beginning of transmission (t₂) of the sequence of synchronisation data symbols includes the following method steps:
- formation of the differences of respectively successive signal levels (S₁) of the received signal,
- comparison of the characteristic of differences of successive signal levels (S₁) of the received signal with a third threshold value (SW₃) in order to determine a time interval (τ) with a rise in the signal level of the received signal greater than a minimum rise in the signal level and
- identification of the beginning of transmission (t₂) of the sequence of synchronisation data symbols, as soon as the time interval (τ) with a rise in the signal level of the received signal greater than the minimum rise in the signal level lies between a fourth and a fifth threshold value (SW₄, SW₅), which respectively set the lower and the upper limit value for the time interval (τ) with a rise in the signal level of the received signal greater than the minimum rise in the signal level.

8. Method according to claim 5,
**characterised in that**
matched filtering of the respectively formed differences is carried out after the formation of the differences.

9. Device for fixing a gain or attenuation factor (G; ATT) for an amplifying or attenuating element (1) during transmission of a sequence of synchronisation data symbols with
a first detector (4) to detect a signal level (S₁) of a received signal at the input of the amplifying or attenuating element (1),
a first unit (7) connected downstream, which determines a beginning of transmission (t₂) of the sequence of synchronisation data symbols, and
a second unit (20) connected downstream, which signals to the amplifying or attenuating element (1) a time interval for the fixing of the gain or attenuation factor (G; ATT),
wherein connected upstream of the second unit (20) there is a third unit (24; 24'; 24") which identifies an invalid signal level on the basis of a difference in signal level between the signal level (S₁) and a second threshold value ((SW₂), and signals a temporary cancellation of the fixing,
wherein the fixing is cancelled for a set first period of time.

10. Device according to claim 9,
**characterised in that**,
in addition there is an average former (21) to determine the average value of the signal level (S₁) of the received signal detected at the input of the amplifying or attenuating element (1), and a first comparator (22) connected between the average former (6) and the second unit (20) in order to identify and signal a prematurely ended fixing.

11. Device according to claim 9,
**characterised in that**
the third unit (24) is connected downstream of the first detector (4) and exhibits a first storage unit (25) to store the signal level (S₁) detected at the beginning of transmission (t₂) of the sequence of synchronisation data symbols by the first detector (4), a second storage unit (26) to store the signal level (S₁) currently detected by the first detector (4), an adder (28) to add the signal level stored in the first storage unit (25) and a second threshold value (SW₂), and a second comparator (29) to signal the temporary cancellation of the fixing in the event of the signal level stored in the second storage unit (26) exceeding the signal level stored in the first storage unit (25) and the second threshold value (SW₂).

12. Device according to claim 9,
**characterised in that**
the third unit (24') is connected downstream of the first detector (4) and exhibits a multiplier (30) to weight the signal level (S₁) of the received signal detected by the first detector (4) with the gain or attenuation factor (G; ATT) of the amplifying or attenuating element (1), and a second comparator (29') connected downstream to signal the temporary cancellation of the fixing in the event of the weighted signal level of the received signal detected by the first detector (4) exceeding a second threshold value ((SW₂).

13. Device according to claim 9,
**characterised in that**
the third unit (24") is connected downstream of a second detector (5) to detect a signal level (S₂) of a received signal at the output of the amplifying or attenuating element (1) and exhibits a second comparator (29") connected downstream to signal the temporary cancellation of the fixing in the event of the signal level (S₂) of the received signal detected by the second detector (5) exceeding a second threshold value ((SW₂).

14. Device according to one of claims 9 to 13,
**characterised in that**
the first unit (7) exhibits a difference former (6) to form differences of signal levels (S₁) of the received signal, a third comparator (15) to determine a time interval (τ) with a rise in the signal level of the received signal greater than a minimum rise in the signal level, a fourth and a fifth comparator (17, 18) to identify and signal the beginning of transmission (t₂) of the sequence of synchronisation data symbols in the event of a time interval (τ) with a rise in the signal level of the received signal greater than the minimum rise in the signal level lying between the fourth and the fifth threshold value (SW₄, SW₅).

15. Device according to claim 14,
**characterised in that**
a matched filter (10) is connected between the difference former (6) and the third comparator (15).

16. Computer programme with programme code means in order to be able to carry out all of the steps according to one of claims 1 to 8 when the programme is executed on a computer or a digital signal processor.

17. Computer programme product with in particular programme code means stored on a machine-readable medium in order to be able to carry out all of the steps according to one of claims 1 to 8 when the programme is executed on a computer or a digital signal processor.

## Revendications

1. Procédé de fixation d'un facteur d'amplification ou d'amortissement (G ; ATT) pour un élément d'amplification ou d'amortissement (1) pendant une transmission d'une séquence de symboles de données de synchronisation comportant les étapes de procédé suivantes :
• la détection d'un niveau de signal (S₁) d'un signal de réception à l'entrée de l'élément d'amplification ou d'amortissement (1),
• l'identification d'un début de transmission (t₂) de la séquence de symboles de données de synchronisation à l'aide du niveau de signal détecté (S₁) du signal de réception et
• la signalisation d'un intervalle de temps commençant avec le début de transmission identifié (t₂) de la séquence de symboles de données de synchronisation de la fixation du facteur d'amplification ou d'amortissement (G ; ATT),
dans lequel une différence de niveau de signal détectée depuis le début (t₂) de l'intervalle de temps de la fixation du facteur d'amplification ou d'amortissement (G ; ATT) du signal de réception (S₁) détecté à l'entrée de l'élément d'amplification ou d'amortissement (1) est comparée à une seconde valeur de seuil (SW₂) en vue de l'identification d'un niveau de signal invalide et la fixation du facteur d'amplification ou d'amortissement (G ; ATT) est supprimée pour une première durée déterminée (τ₁), dès que la différence de niveau de signal détectée dépasse la seconde valeur de seuil (SW₂).

2. Procédé selon la revendication 1, **caractérisé en ce que**
l'intervalle de temps de la fixation du facteur d'amplification ou d'amortissement (G ; ATT) est terminée au plus tard après une durée de transmission (τ_{Fix}) pour la séquence de symboles de données de synchronisation.

3. Procédé selon les revendications 1 et 2, **caractérisé en ce que**
le niveau de signal détecté (S₁) du signal de réception est moyenné sur un intervalle de moyennage déterminé et est comparé à une première valeur de seuil (SW₁) en vue de l'identification d'une fixation préalablement terminée et l'intervalle de temps de la fixation du facteur d'amplification ou d'amortissement est terminé prématurément, si le niveau de signal moyenné du signal de réception descend en dessous de la première valeur de seuil (SW₁).

4. Procédé selon l'une des revendications 1 à 3, **caractérisé en ce que**
depuis le début (t₂) de l'intervalle de temps de la fixation du facteur d'amplification ou d'amortissement (G; ATT), le niveau de signal (S₁) multiplié par le facteur fixé d'amplification ou d'amortissement (G ; ATT) et détecté à l'entrée de l'élément d'amplification ou d'amortissement (1) du signal de réception est comparé à la seconde valeur de seuil (SW₂) en vue de l'identification d'un niveau de signal invalide et la fixation du facteur d'amplification ou d'amortissement (G ; ATT) est supprimée pour une première durée de temps déterminée (τ₁), dès que le niveau de signal (S₁) multiplié par le facteur fixé d'amplification ou d'amortissement (G ; ATT) du signal de réception dépasse la seconde valeur de seuil (SW₂).

5. Procédé selon l'une des revendications 1 à 3, **caractérisé en ce que**
depuis le début (t₂) de l'intervalle de temps de la fixation du facteur d'amplification ou d'amortissement (G; ATT), un niveau de signal (S₂) détecté à la sortie de l'élément d'amplification ou d'amortissement (1) du signal de réception est comparé à la seconde valeur de seuil (SW₂) en vue de l'identification d'un niveau de signal invalide et la fixation du facteur d'amplification ou d'amortissement (G; ATT) est supprimée pour une première durée de temps déterminée (τ₁), dès que le niveau de signal détecté (S₂) du signal de réception dépasse la seconde valeur de seuil (SW₂).

6. Procédé selon l'une quelconque des revendications 1 à 5, **caractérisé en ce que**
la comparaison du niveau de signal détecté (S₁, S₂) du signal de réception est limitée à la seconde valeur de seuil (SW₂) sur une seconde durée de temps (τ₂), qui est réduite par rapport à la durée de transmission (τ_{Fix}) pour la séquence de symboles de données de synchronisation.

7. Procédé selon l'une quelconque des revendications 1 à 6, **caractérisé en ce que**
l'identification du début de transmission (t₂) de la séquence de symboles de données de synchronisation comporte les étapes de procédé suivantes :
• la formation d'une différence des niveaux de signal consécutifs respectifs (S₁) du signal de réception,
• la comparaison du tracé des différences des niveaux de signal consécutifs (S₁) du signal de réception à une troisième valeur de seuil (SW₃) en vue de la détermination d'un intervalle de temps (τ) à une augmentation du niveau de signal plus grande par rapport à une augmentation du niveau de signal minimum du signal de réception et
• l'identification du début de transmission (t₂) de la séquence de symboles de données de synchronisation, dès que l'intervalle de temps (τ) avec une augmentation de niveau de signal supérieure par rapport à l'augmentation de niveau de signal minimum du signal de réception se trouve entre une quatrième et une cinquième valeur de seuil (SW₄, SW₅), qui détermine la valeur limite inférieure ou supérieure pour l'intervalle de temps (τ) avec une augmentation du niveau de signal supérieure par rapport à l'augmentation de niveau de signal minimum du signal de réception.

8. Procédé selon la revendication 5, **caractérisé en ce que**
un filtrage adapté des différences formées respectives est effectué après la formation des différences.

9. Dispositif pour fixer un facteur d'amplification ou d'amortissement (G ; ATT) pour un élément d'amplification ou d'amortissement (1) pendant une transmission d'une séquence de symboles de données de synchronisation comportant
un premier détecteur (4) pour détecter un niveau de signal (S₁) d'un signal de réception à l'entrée de l'élément d'amplification ou d'amortissement (1),
une première unité placée en aval (7), qui détecte un début de transmission (t₂) de la séquence de symboles de données de synchronisation, et
une seconde unité placée en aval (20), qui signale à l'élément d'amplification ou d'amortissement (1) un intervalle de temps de la fixation du facteur d'amplification ou d'amortissement (G ; ATT),
dans lequel la seconde unité (20) est placée en amont d'une troisième unité (24 ; 24' ; 24"), qui identifie un niveau de signal invalide à l'aide d'une différence de niveau de signal entre le niveau de signal (S₁) et une seconde valeur de seuil (SW₂), et signale une suppression temporaire de la fixation, dans laquelle la fixation est supprimée pour une première durée de temps déterminée.

10. Dispositif selon la revendication 9, **caractérisé en ce que**
un dispositif de formation de valeur moyenne (21) en vue de la détection de la valeur moyenne du niveau de signal (S₁) détecté à l'entrée de l'élément d'amplification ou d'amortissement (1) du signal de réception et un premier comparateur (22) monté entre le dispositif de formation de valeur moyenne (6) et la seconde unité (20) sont prévus de plus pour l'identification et la signalisation d'une fixation terminée prématurément.

11. Dispositif selon la revendication 9, **caractérisé en ce que**
la troisième unité (24) est placée en aval du premier détecteur (4) et présente une première unité de stockage (25) en vue du stockage du niveau de signal (S₁) détecté par le premier détecteur (4) au début de la transmission (t₂) de la séquence de symboles de données de synchronisation, une seconde unité de stockage (26) pour le stockage du niveau de signal (S₁) détecté actuellement par le premier détecteur (4), un additionneur (28) pour additionner le niveau de signal stocké dans la première unité de stockage (25) et une seconde valeur de seuil (SW₂) et un second comparateur (29) pour signaler la suppression temporaire de la fixation lors du dépassement du niveau de signal stocké dans la première unité de stockage (25) et de la seconde valeur de seuil (SW₂) par le niveau de signal stocké dans la seconde unité de stockage (26).

12. Dispositif selon la revendication 9, **caractérisé en ce que**
la troisième unité (24') est placée en aval du premier détecteur (4) et présente un multiplicateur (30) pour pondérer le niveau de signal (S₁) détecté par le premier détecteur (4) du signal de réception par le facteur d'amplification ou d'amortissement (G ; ATT) de l'élément d'amplification ou d'amortissement (1) et un second comparateur placé en aval (29') pour la signalisation de la suppression temporaire de la fixation lors du dépassement d'une seconde valeur de seuil (SW₂) par le niveau de signal pondéré du signal de réception détecté par le premier détecteur (4).

13. Dispositif selon la revendication 9, **caractérisé en ce que**
la troisième unité (24") est placée en aval d'un second détecteur (5) pour détecter un niveau de signal (S₂) d'un signal de réception à la sortie de l'élément d'amplification ou d'amortissement (1) et présente un second comparateur placé en aval (29") pour signaler la suppression temporaire de la fixation lors du dépassement d'une seconde valeur de seuil (SW₂) par le niveau de signal (S₂) détecté par le second détecteur (5) du signal de réception.

14. Dispositif selon l'une des revendications 9 à 13, **caractérisé en ce que**
la première unité (7) présente un dispositif de formation de différences (6) pour former les différences de niveau de signal (S₁) du signal de réception, un troisième comparateur (15) pour déterminer un intervalle de temps (τ) avec une augmentation du niveau de signal supérieure par rapport à une augmentation de niveau de signal minimum du signal de réception, un quatrième ou un cinquième comparateur (17, 18) pour identifier et signaler le début de transmission (t₂) de la séquence de symboles de données de synchronisation dans le cas d'un intervalle de temps (τ) se trouvant entre la quatrième et la cinquième valeur de seuil (SW₄, SW₅) avec une augmentation du niveau de signal supérieure par rapport à l'augmentation de niveau de signal minimum du signal de réception.

15. Dispositif selon la revendication 14, **caractérisé en ce que**
un filtre adapté (10) est monté entre le dispositif de formation de différences (6) et le troisième comparateur (15).

16. Programme informatique comportant des moyens de code de programme, permettant d'effectuer toutes les étapes selon l'une des revendications 1 à 8, lorsque le programme est mis en oeuvre sur un ordinateur ou un processeur de signal numérique.

17. Produit de programme informatique comportant en particulier des moyens de code de programme mémorisés sur un support pouvant être lu par une machine, permettant d'effectuer toutes les étapes selon l'une des revendications 1 à 8, lorsque le programme est mis en oeuvre sur un ordinateur ou sur un processeur de signal numérique.
